# FASCICULE DE BREVET EUROPEEN

(11) **EP 0 696 031 B1**
(45) Date de publication et mention de la délivrance du brevet: **18.12.1996**
(21) Numéro de dépôt: 95401709.1
(22) Date de dépôt: 18.07.1995
(51) Int. Cl.: G11C 29/00, G06F 11/26, G11C 16/06

(54) **Mémoire intégrée programmable comportant des moyens d'émulation**
Programmierbarer integrierter Speicher mit Emulationseinrichtung
Programmable integrated memory with emulation means

(30) Priorité: 20.07.1994 FR 9409202
(43) Date de publication de la demande: 07.02.1996
(73) Titulaire: SGS-THOMSON MICROELECTRONICS S.A., 94250 Gentilly (FR)
(72) Inventeur: Gaultier, Jean-Marie Bernard, F-94230 Cachan (FR)
(74) Mandataire: Schmit, Christian Norbert Marie

(56) Documents cités:
- EP-A- 0 385 591
- US-A- 5 151 881
- PATENT ABSTRACTS OF JAPAN vol. 18, no. 89 (P-1692) 14 Février 1994 & JP-A-05 290 185 (YOKOGAWA ELECTRIC CO.)
- PATENT ABSTRACTS OF JAPAN vol. 18, no. 89 (P-1692) 14 Février 1994 & JP-A-05 290 185

## Description

L'invention se situe principalement dans le domaine des mémoires intégrées programmables, telles que les mémoires "EEPROM" ou "FLASH EEPROM".

EP-A-0 385 591 décrit une machine d'état pour détecter des défauts d'une mémoire et qui impose des signaux de test sur les données d'entrées et les signaux de contrôle et qui analyse le signal de sortie série de données.

JP-A-05 290 185 concerne le test d'un ASIC comprenant une machine détat. Pour le test il est prévu que la machine d'état comprenne un multiplexeur qui transmet en mode normal l'état suivant et qui en test transmet un état imposé en externe sur des moyens bi-directionnels.

Les mémoires du type intégré programmable développées actuellement se présentent sous la forme de circuits intégrés contenant un ensemble de ressources permettant la programmation et éventuellement l'effacement des cellules mémoire. Ces ressources sont notamment des générateurs de tension de programmation et d'effacement, des circuits de contrôle par relecture des données programmées ou effacées ou des générateurs d'adresse servant à l'effacement automatique de la totalité de la mémoire ou de certains secteurs sélectionnés. Ces ressources sont contrôlées par une unité de commande intégrée capable d'exécuter des algorithmes adaptés aux opérations à effectuer et aux ressources commandées.

L'unité de commande est une machine d'état pouvant être réalisée au moyen d'un réseau logique programmé (PLA) ou d'une unité microprogrammée. Pour des raisons d'encombrement, la machine d'état est généralement câblée, ce qui a pour conséquence que les algorithmes exécutables ne peuvent pas être modifiés après fabrication du circuit intégré.

La mise au point de tels produits est facilitée grâce à des programmes de simulation applicables à la technologie utilisée. Toutefois, ces programmes ne reflètent pas parfaitement la réalité et ne permettent donc pas de se dispenser de tests réels que l'on fait subir à des prototypes. Typiquement, ces tests consistent à effectuer des successions de programmation et d'effacement suivies de relecture permettant de détecter les divergences entre les données qui auraient dû être écrites et les données lues. On peut également réaliser ces tests en imposant à la mémoire des conditions extrêmes de fonctionnement, par exemple en la plaçant dans une étuve.

Ces tests visent bien entendu à déceler l'origine des défauts constatés pour modifier en conséquence certains paramètres de conception ou de fabrication. Ainsi, les méthodes de conception actuelles nécessitent généralement la fabrication de plusieurs séries de prototypes incorporant des améliorations successives résultant des analyses des tests effectués.

La recherche des causes de défauts constatés est rendue possible grâce à des modes de test intégrés permettant notamment d'extraire de la mémoire des indicateurs représentatifs de l'état logique des principaux circuits qui la composent. Pour certains types de défauts, tels que ceux liés aux dispersions de fabrication et au vieillissement, des améliorations peuvent être obtenues simplement par une modification des algorithmes exécutables par la machine d'état. Toutefois, la détermination optimale des modifications à apporter peut nécessiter la fabrication de nombreux prototypes. Il en résulte une augmentation des coûts et des délais de développement de tels produits.

L'invention a pour but de remédier à cet inconvénient en proposant une mémoire conçue pour fonctionner selon un mode d'émulation permettant de substituer à la machine d'état un testeur extérieur au circuit intégré. Cette disposition permettra alors de tester de nouveaux algorithmes sans qu'il soit nécessaire de fabriquer des prototypes correspondants.

Dans ce but, l'invention a pour objet une mémoire intégrée programmable comprenant :
- une matrice de cellules mémoire adressables,
- des moyens d'alimentation prévus pour appliquer sélectivement des tensions de programmation et d'effacement auxdites cellules mémoire en fonction de signaux internes de commande véhiculés par des lignes internes de commande,
- un circuit d'interface relié à des lignes externes de données et d'adresse pour échanger des données et pour transférer des signaux externes d'adresse sur des lignes internes correspondantes,
- une unité de commande utilisateur recevant des signaux externes de commande et prévue notamment pour contrôler ledit échange de données en fonction desdits signaux externes de commande,
- une machine d'état prévue pour exécuter au moins un algorithme activable par l'unité de commande utilisateur en fonction des signaux externes de commande reçus, l'exécution dudit algorithme ayant pour effet de produire des signaux de sortie,
ladite mémoire étant caractérisée en ce qu'elle comporte des moyens de détection sensibles à des signaux externes de commande prédéterminés et des premiers moyens de sélection commandés par lesdits moyens de détection pour faire fonctionner la mémoire sélectivement selon un mode normal ou un mode d'émulation et en ce que lesdits premiers moyens de sélection sont prévus pour placer en mode normal lesdits signaux de sortie de la machine d'état sur lesdites lignes internes de commande et, en mode d'émulation, pour mettre en communication une partie au moins desdites lignes internes d'adresse avec lesdites lignes internes de commande.

Au cas où la mémoire est munie d'un séquenceur et d'une horloge intégrée, il est généralement nécessaire de synchroniser le séquencement de l'algorithme à partir d'un même signal d'horloge que celui servant à synchroniser le séquenceur. Pour cela, on pourrait prévoir la possibilité d'extraire du circuit intégré le signal d'horloge de base en vue de le transmettre au testeur. Il est toutefois préférable en mode d'émulation de synchroniser la mémoire à partir d'un signal d'horloge fourni par le testeur.

Aussi, selon un autre aspect de l'invention, la mémoire est caractérisée en ce que ladite machine d'état comporte un séquenceur synchronisé par au moins un signal d'horloge de base et en ce que des seconds moyens de sélection commandés par lesdits moyens de détection sont prévus pour délivrer ledit ou lesdits signaux d'horloge de base sélectivement à partir d'une horloge interne en mode normal ou à partir d'au moins une desdites lignes internes d'adresse en mode d'émulation.

Cette solution présente l'avantage de simplifier le contrôle des échanges entre le testeur et le circuit intégré. De plus, elle permet d'effectuer des essais en modifiant la fréquence d'horloge de base.

Dans le cas où la machine d'état est munie de bornes d'entrée destinées à recevoir des signaux d'entrée d'au moins un des circuits de la mémoire, l'invention prévoit en outre des troisièmes moyens de sélection commandés par lesdits moyens de détection et prévus pour fournir en mode d'émulation lesdits signaux d'entrée audit circuit d'interface en vue de les placer sur lesdites lignes externes de données.

Avantageusement, le circuit d'interface et les premiers, seconds et troisièmes moyens de sélection sont conçus pour permettre un fonctionnement en temps réel.

Au cas où la machine d'état est prévue pour commander une pluralité de circuits de la mémoire, l'invention prévoit également que les lignes internes de commande constituent un bus de commande et qu'une partie au moins des circuits commandés sont munis de décodeurs reliés au bus de sorte que le nombre de lignes constituant le bus de commande ne soit pas supérieur au nombre de lignes internes d'adresse.

Cette dernière disposition permet ainsi une mise en oeuvre du mode d'émulation sans qu'il soit nécessaire de prévoir des lignes externes supplémentaires ou d'utiliser les lignes externes de données.

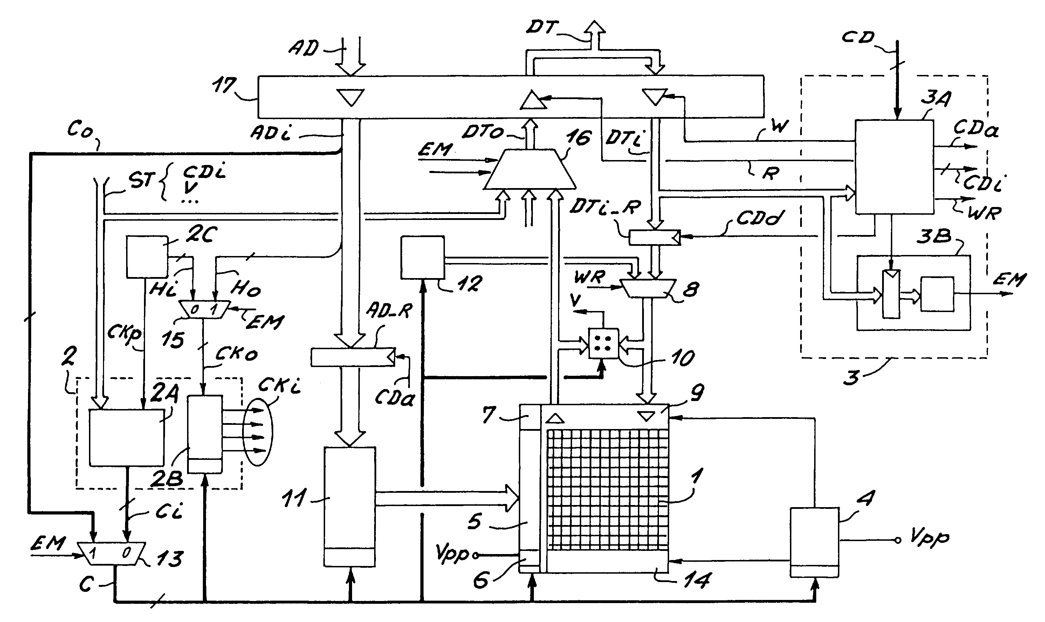

D'autres aspects et avantages de l'invention apparaîtront dans la suite de la description.
- La figure unique représente un schéma d'ensemble d'une mémoire conforme à l'invention.

A titre d'exemple non limitatif, la mémoire représentée sur la figure est de type "FLASH EEPROM".

La mémoire est essentiellement constituée d'une matrice 1 de cellules mémoire organisée en rangées et en colonnes. La sélection des rangées s'effectue au moyen d'un décodeur de rangées 5 tandis que les colonnes sont sélectionnées au moyen d'un décodeur de colonnes 7 associé à un circuit de sélection 9. Les décodeurs de rangées et de colonnes reçoivent une adresse fournie par un générateur d'adresse 11.

Dans le cas d'une mémoire de type "FLASH EEPROM", chaque cellule mémoire est constituée d'un transistor MOS à grille flottante dont le seuil de conduction est modifiable par l'application sur ses électrodes de tension appropriée. Ainsi, la programmation d'une cellule consiste à créer un seuil élevé par l'application de tension de programmation sur la grille et sur le drain, la source étant à la masse. Inversement, une opération d'effacement consiste à créer un seuil bas par l'application d'une tension d'effacement sur la source du transistor, sa grille étant à la masse et son drain placé à l'état de haute impédance. Ainsi, pour ce type de mémoire, on prévoit un générateur de tensions de programmation des colonnes 4 alimentant les drains par l'intermédiaire du circuit de sélection des colonnes 9 et alimentant les sources par l'intermédiaire d'un circuit d'alimentation des sources 14. Il est d'autre part prévu un circuit d'alimentation des rangées 6 permettant d'appliquer sur les grilles la tension de programmation. Ces moyens d'alimentation reçoivent un potentiel Vpp dit de haute tension fourni par l'extérieur du circuit intégré.

La mémoire communique avec l'extérieur par l'intermédiaire d'un circuit d'interface 17 relié à des lignes externes d'adresse AD et de données DT. Le circuit d'interface 17 permet de transférer les signaux externes d'adresse AD sur des lignes internes d'adresse ADi reliées au générateur d'adresse 11 par l'intermédiaire d'un registre d'adresse AD-R. Les données échangées entre la matrice 1 et l'extérieur par les lignes DT transitent par l'intermédiaire de lignes DTi et d'un registre de données d'entrée DTi-R et d'un multiplexeur ou sélecteur de données 8 pour l'écriture et par l'intermédiaire de lignes de données de sortie DTo et d'un autre multiplexeur 16 pour la lecture. Le multiplexeur 8 dont la sortie est reliée au circuit de sélection des colonnes 9 par des lignes d'écriture a une seconde entrée reliée à un générateur de données 12. Le sélecteur des colonnes 9 est par ailleurs relié à une entrée du multiplexeur 16 par des lignes de lecture. Les lignes d'écriture et de lecture sont reliées aux entrées d'un comparateur 10 fournissant en sortie un signal de comparaison V.

La mémoire comprend par ailleurs une unité de commande utilisateur 3 recevant des signaux externes de commande CD. L'unité 3 est essentiellement constituée d'une interface de commande 3A et d'un circuit de test 3B. L'interface de commande 3A reçoit directement les signaux externes de commande CD et est d'autre part relié aux lignes de données d'entrée DTi.

L'interface 3A est prévu pour prendre en compte les signaux externes de commande CD et les interpréter en fonction de données placées sur les lignes de données DT. En fonction de cette interprétation, l'interface 3A fournit des signaux de commande CDa, CDi, W, R, CDd.

La mémoire comporte d'autre part une machine d'état 2 associée à une horloge 2C. La machine d'état 2 est constituée d'un réseau logique programmable (PLA) 2A et d'un séquenceur 2B fournissant des signaux de minutage CKi. Le réseau logique programmable 2A reçoit des signaux d'entrée ST ainsi qu'un signal d'horloge CKp fourni par l'horloge 2C. Il délivre des signaux de commande Ci sur un bus interne de commande C par l'intermédiaire d'un multiplexeur 13 dont la seconde entrée est reliée à une partie Co des lignes internes d'adresse ADi. Le bus C est relié au séquenceur 2B, au générateur d'adresse 11, au générateur de donnée 12, au comparateur 10, au circuit d'alimentation des rangées 6 et au générateur de tension d'alimentation des colonnes 4. Les signaux d'entrée ST sont constitués de signaux de commande CDi fournis par l'interface 3A ainsi que d'un ensemble de variables d'état des différentes ressources du circuit. Les signaux ST sont appliqués à une des entrées du multiplexeur 16.

Le séquenceur 2B est synchronisé par un signal d'horloge de base CK0 fourni par un multiplexeur 15 dont une entrée reçoit un ou plusieurs signaux d'horloge Hi fournis par l'horloge 2C et dont la seconde entrée est reliée à une partie Ho des lignes internes d'adresse ADi.

Le circuit de test 3B comporte un registre dont l'entrée est reliée aux lignes de données d'entrée DTi. Sa sortie est reliée à un décodeur fournissant un signal de détection de mode d'émulation EM. Le registre est commandé par l'interface de commande 3A. Le signal de détection de mode d'émulation EM constitue une commande des multiplexeurs 13, 15, 16.

La seconde entrée du multiplexeur 13 est reliée à une partie C0 des lignes internes d'adresse ADi.

Selon l'état du signal EM, la mémoire est positionnée pour fonctionner soit en mode normal, soit en mode d'émulation. En mode normal, les multiplexeurs 13, 15, 16 autorisent respectivement le transfert des signaux Ci sur le bus C, des signaux Ho vers le séquenceur 2B et des lignes de lecture vers les lignes DTo.

De façon classique, la mémoire est prévue pour effectuer des opérations de lecture, d'écriture et d'effacement global ou par secteur du plan mémoire. Dans l'exemple représenté, ces opérations sont activées en fonction des signaux externes de commande CD et de données associées présentes sur les lignes DT. En réponse à la commande externe reçue, l'interface 3A fournit les signaux appropriés tels que le signal CDa commandant le chargement du registre d'adresse AD-R ainsi que le signal CDd commandant le chargement du registre de données d'entrée DTi-R s'il s'agit d'une écriture. L'interface 3A fournit d'autre part les signaux de commande CDi au réseau logique programmé 2A de façon à activer l'exécution de l'algorithme correspondant à l'opération à effectuer.

Selon un aspect de réalisation particulier, l'unité de commande utilisateur 3 sera prévue pour fonctionner en deux phases successives : une première phase pendant laquelle l'extérieur fournit une commande de prépositionnement permettant à l'interface 3A d'identifier le type de commande (lecture, écriture, effacement) et une deuxième phase pendant laquelle l'extérieur fournit une commande d'exécution associée aux paramètres d'exécution (adresse, donnée à écrire). Pendant la deuxième phase, l'interface 3A commande le chargement de ces paramètres d'exécution dans les registres correspondants (AD-R, DTi-R). Simultanément, l'interface 3A fournit les commandes appropriées CDi à la machine d'état 2.

Ainsi, pour une opération d'écriture, une adresse est chargée dans le registre d'adresse AD-R et la donnée à écrire est chargée dans le registre DTi-R. Le générateur d'adresse 11 est positionné pour mettre en communication le registre AD-R avec les décodeurs 5 et 7. Le sélecteur de données 8 est positionné par le signal WR pour que le registre DTi-R commande le sélecteur des colonnes 9 de façon à appliquer en fonction de la donnée à écrire une tension de programmation sur les drains des cellules sélectionnées par l'adresse. La machine d'état exécute alors l'algorithme correspondant à une opération d'écriture. L'algorithme consistera par exemple à activer le circuit d'alimentation 6 de façon à appliquer une impulsion de programmation calibrée sur les grilles des transistors de la rangée sélectionnée. Une lecture est ensuite effectuée pour comparer l'état de conduction des cellules à programmer à une cellule programmée de référence. Les divergences sont signalées à la machine d'état 2 par le comparateur 10 au moyen du signal de comparaison V qui constitue l'un des signaux d'entrée ST évoqués précédemment. En cas de divergence, l'algorithme provoque à nouveau une impulsion de programmation sur les grilles. Une nouvelle lecture et une nouvelle comparaison sont alors effectuées pour déterminer si une nouvelle impulsion de programmation est nécessaire. Ce cycle se répète aussi longtemps qu'une différence est détectée.

Une opération d'effacement de la mémoire s'effectue par l'exécution de deux algorithmes successifs : un algorithme de programmation avant effacement et un algorithme d'effacement proprement dit. Le sélecteur de données 8 est positionné pour permettre au générateur de donnée 12 de commander le circuit d'alimentation des colonnes 9. Pour exécuter l'algorithme de programmation avant effacement, la machine d'état commande le générateur de donnée 12 pour qu'il fournisse en sortie une valeur logique correspondant à l'état programmé des cellules. La machine d'état commande d'autre part le générateur d'adresse pour qu'il mette en communication les décodeurs de rangées et de colonnes avec un compteur d'adresse (non représenté) initialement à zéro. La machine d'état 2 déclenche alors un cycle de programmation qui commande d'abord le circuit d'alimentation 6 pour fournir une impulsion de programmation sur les grilles. Puis, comme pour l'écriture, les données sont lues et comparées pour déterminer si une nouvelle impulsion de programmation est nécessaire. Dans l'affirmative, un nouveau cycle de programmation est effectué. Les cycles de programmation se répètent ainsi jusqu'à ce que le comparateur 10 ne détecte plus de différence. La machine d'état 3 fournit alors au générateur d'adresse 11 un signal de commande d'incrémentation de façon à augmenter d'une unité l'adresse appliquée au décodeur 5 et 7. La machine d'état commande alors de nouveaux cycles de programmation de la façon indiquée précédemment. A la fin de ces cycles, le compteur est à nouveau incrémenté. L'opération se répète ainsi jusqu'à ce que le compteur fournisse un signal de dépassement constituant un signal d'état transmis à la machine d'état.

En réponse à ce signal d'état, la machine d'état se branche alors sur un algorithme d'effacement qui consiste d'abord à commander le générateur de donnée 12 pour qu'il fournisse en sortie une valeur logique correspondant à l'état effacé des cellules. Elle commande ensuite le générateur de tensions 4 pour qu'il alimente les sources avec une tension d'effacement. L'algorithme se poursuit par une succession de lecture et de comparaison visant à comparer l'état de conduction des cellules à effacer à une cellule effacée de référence. En cas de différence, la tension d'effacement est à nouveau appliquée sur les sources et une nouvelle vérification systématique de toutes les cellules est à nouveau effectuée. Ce cycle se répète aussi longtemps qu'une différence est détectée par le comparateur 10.

Pour faire fonctionner la mémoire en mode d'émulation, on applique un signal de commande CD particulier de mise en mode de test associé à des données DT identifiant le mode d'émulation. En réponse à ce signal de commande, l'interface 3A commande le chargement des données dans le registre correspondant du circuit de test 3B. Le décodeur fournit alors le signal de commande de mode d'émulation EM.

Le multiplexeur 13 est alors positionné pour mettre en communication les lignes C0 avec le bus interne de commande C. De même, le multiplexeur 15 est positionné pour délivrer les signaux d'horloge de base CK0 à partir de lignes internes d'adresse H0. Enfin, le multiplexeur 16 est positionné pour placer les signaux d'entrée ST sur les lignes internes de sortie DTo.

Par ailleurs, pour mettre en communication la sortie du multiplexeur 16 avec les lignes externes de données DT, on applique un signal externe de commande de lecture afin d'activer les amplificateurs de sortie de l'interface 17.

On peut alors utiliser un testeur branché sur les lignes AD et DT. Ce testeur pourra alors être programmé pour exécuter les algorithmes que l'on souhaite mettre au point.

En appliquant ensuite les commandes normales d'écriture ou d'effacement, l'interface de commande 3A génère les signaux CDi correspondants. Ces signaux sont alors transmis au testeur par le multiplexeur 16 et les lignes externes de données DT. Le testeur exécute alors l'algorithme correspondant avec pour effet l'envoi de commande sur le bus C par l'intermédiaire des lignes AD et ADi et du multiplexeur 13. Simultanément, le testeur envoie les signaux d'horloge de base CKo par l'intermédiaire des lignes AD et ADi et du multiplexeur 15.

## Revendications

1. Mémoire intégrée programmable comprenant :
- une matrice (1) de cellules mémoire adressables,
- des moyens d'alimentation (4, 6, 9, 14) prévus pour appliquer sélectivement des tensions de programmation et d'effacement auxdites cellules mémoire en fonction de signaux internes de commande véhiculés par des lignes internes de commande (C),
- un circuit d'interface (17) relié à des lignes externes de données (DT) et d'adresse (AD) pour échanger des données et pour transférer des signaux externes d'adresse sur des lignes internes (ADi) correspondantes,
- une unité de commande utilisateur (3) recevant des signaux externes de commande (CD) et prévue notamment pour contrôler ledit échange de données en fonction desdits signaux externes de commande (CD),
- une machine d'état (2) prévue pour exécuter au moins un algorithme activable par l'unité de commande utilisateur (3) en fonction des signaux externes de commande (CD) reçus, l'exécution dudit algorithme ayant pour effet de produire des signaux de sortie (Ci),
ladite mémoire étant caractérisée en ce qu'elle comporte des moyens de détection (3B) sensibles à des signaux externes de commande prédéterminés et des premiers moyens de sélection (13) commandés par lesdits moyens de détection (3B) pour faire fonctionner la mémoire sélectivement selon un mode normal ou un mode d'émulation et en ce que lesdits premiers moyens de sélection (13) sont prévus pour placer en mode normal lesdits signaux de sortie (Ci) de la machine d'état (2) sur lesdites lignes internes de commande (C) et, en mode d'émulation, pour mettre en communication une partie (C0) au moins desdites lignes internes d'adresse (ADi) avec lesdites lignes internes de commande (C).

2. Mémoire selon la revendication 1, caractérisée en ce que ladite machine d'état (2) comporte un séquenceur (2B) synchronisé par au moins un signal d'horloge de base (CK0) et en ce que des seconds moyens de sélection (15) commandés par lesdits moyens de détection (3B) sont prévus pour délivrer ledit ou lesdits signaux d'horloge de base (CK0) sélectivement à partir d'une horloge interne (2C) en mode normal ou à partir d'au moins une desdites lignes internes d'adresse (ADi) en mode d'émulation.

3. Mémoire selon l'une des revendications 1 ou 2, caractérisée en ce que ladite machine d'état étant munie de bornes d'entrée destinées à recevoir des signaux d'entrée (ST) d'au moins un des circuits de la mémoire, des troisièmes moyens de sélection (16) commandés par lesdits moyens de détection (3B) sont prévus pour fournir en mode d'émulation lesdits signaux d'entrée (ST) audit circuit d'interface (17) en vue de les placer sur lesdites lignes externes de données (DT).

4. Mémoire selon la revendication 3, caractérisée en ce que ledit circuit d'interface (17) et lesdits premiers, seconds et troisièmes moyens de sélection (13, 15, 16) permettent un fonctionnement en temps réel.

5. Mémoire selon l'une des revendications 1 à 4, caractérisée en ce que ladite machine d'état étant prévue pour commander une pluralité de circuits (2B, 4, 6, 10, 11, 12) de la mémoire, lesdites lignes internes de commande (C) constituent un bus de commande et en ce qu'une partie au moins desdits circuits commandés sont munis de décodeurs reliés audit bus de sorte que le nombre de lignes constituant le bus de commande (C) ne soit pas supérieur au nombre de lignes internes d'adresse (ADi).

6. Mémoire selon l'une des revendications 1 à 5, caractérisée en ce qu'en mode normal ladite unité de commande utilisateur (3) est prévue pour fonctionner en réponse à deux commandes successives :
- une première commande de prépositionnement en réponse à laquelle l'unité de commande utilisateur (3) identifie le type d'opération à effectuer, telle que l'effacement ou la programmation de cellules de la matrice (1) et
- une seconde commande d'exécution en réponse à laquelle l'unité de commande utilisateur (3) commande le chargement dans des registres internes (AD-R, DTi-R) de paramètres d'exécution, tels que l'adresse ou les données à écrire, de l'opération à effectuer,
lesdits signaux externes de commande prédéterminés étant appliqués avant ladite première commande de positionnement.

## Patentansprüche

1. Programmierbarer integrierter Speicher, umfassend:
- eine Matrix (1) von adressierbaren Speicherzellen,
- Versorgungsmittel (4, 6, 9, 14), die zum selektiven Anlegen von Programmier- und Löschspannungen an die Speicherzellen in Abhängigkeit von internen, über interne Steuerleitungen (C) transportierte Steuersignale vorgesehen sind,
- eine Schnittstellenschaltung (17), die mit externen Datenleitungen (DT) und Adreßleitungen (AD) verbunden ist zum Austauschen von Daten und zum Übertragen von externen Adreßsignalen auf entsprechenden internen Leitungen (ADi),
- eine Anwender-Steuereinheit (3), die externe Steuersignale (CD) empfängt und insbesondere dazu vorgesehen ist, den Datenaustausch in Abhängigkeit von den externen Steuersignalen (CD) zu steuern,
- eine Zustandsmaschine (2), die zum Ausführen zumindest eines durch die Anwender-Steuereinheit (3) in Abhängigkeit von empfangenen, externen Steuersignalen (CD) aktivierbaren Algorithmus vorgesehen ist, wobei die Ausführung des Algorithmus bewirkt, daß Ausgangssignale (Ci) erzeugt werden,
dadurch gekennzeichnet, daß Erfassungsmittel (3B), die für vorbestimmte externe Steuersignale empfindlich sind, und erste Auswahlmittel (13), die durch die Erfassungsmittel (3B) so gesteuert werden, daß sie den Speicher selektiv entsprechend einer Normalbetriebsart oder einer Emulationsbetriebsart arbeiten lassen, vorgesehen sind, und daß die ersten Auswahlmittel (13) dazu vorgesehen sind, in der Normalbetriebsart die Ausgangssignale (Ci) der Zustandsmaschine (2) auf die internen Steuerleitungen (C) zu legen und in der Emulationsbetriebsart zumindest einen Teil (C0) der internen Adreßleitungen (ADi) mit den internen Steuerleitungen (C) zu verbinden.

2. Speicher nach Anspruch 1, dadurch gekennzeichnet, daß die Zustandsmaschine (2) eine Folgesteuerung (2B) umfaßt, die mittels zumindest einem Basistaktsignal (CK0) synchronisiert ist, und daß zweite, durch die Erfassungsmittel (3B) gesteuerte Auswahlmittel (15) vorgesehen sind, um das oder die Basistaktsignal(e) (CK0) selektiv, in der Normalbetriebsart, über einen internen Taktgeber (2C) oder, in der Emulationsbetriebsart, über zumindest eine der internen Adreßleitungen (ADi) bereitzustellen.

3. Speicher nach einem der Ansprüche 1 oder 2, dadurch gekennzeichnet, daß die Zustandsmaschine mit Eingangsklemmen versehen ist, die dazu bestimmt sind, Eingangssignale (ST) von zumindest einem der Schaltkreise des Speichers zu empfangen, und daß dritte, durch die Erfassungsmittel (3B) gesteuerte Auswahlmittel (16) vorgesehen sind zum Liefern der Eingangssignale (ST) an die Schnittstellenschaltung (17) in der Emulationsbetriebsart, um diese auf die externen Datenleitungen (DT) zu legen.

4. Speicher nach Anspruch 3, dadurch gekennzeichnet, daß die Schnittstellenschaltung (17) und die ersten, zweiten und dritten Auswahlmittel (13, 15, 16) einen Echtzeitbetrieb erlauben.

5. Speicher nach einem der Ansprüche 1 bis 4, dadurch gekennzeichnet, daß die Zustandsmaschine zum Steuern einer Vielzahl von Schaltkreisen (2B, 4, 6, 10, 11, 12) des Speichers vorgesehen ist, die internen Steuerleitungen (C) einen Steuerbus bilden, und dadurch, daß zumindest ein Teil der gesteuerten Schaltkreise mit Dekodierern versehen sind, die so mit dem Bus verbunden sind, daß die Anzahl der den Steuerbus (C) bildenden Leitungen nicht größer als die Anzahl der internen Adreßleitungen (ADi) ist.

6. Speicher nach einem der Ansprüche 1 bis 5, dadurch gekennzeichnet, daß die Anwender-Steuereinheit (3) in der Normalbetriebsart dazu vorgesehen ist, in Antwort auf zwei aufeinanderfolgende Anweisungen zu arbeiten:
- eine erste Anweisung zur Voreinstellung, auf die hin die Anwender-Steuereinheit (3) die Art des auszuführenden Vorgangs, beispielsweise das Löschen oder die Programmierung der Zellen der Matrix (1), identifiziert, und
eine zweite Anweisung zur Ausführung, auf die hin die Anwender-Steuereinheit (3) das Laden von Ausführungsparametern der auszuführenden Operation, beispielsweise die Adresse oder die zu schreibenden Daten, in interne Register (AD-R, DTi-R) veranlaßt,
wobei die vorbestimmten externen Steuersignale vor der ersten Anweisung zur Einstellung angelegt werden.

## Claims

1. Programmable integrated memory comprising:
- a matrix (1) of addressable memory cells,
- supply means (4, 6, 9, 14) provided in order selectively to apply programming and erasure voltages to the said memory cells according to internal control signals conveyed via internal control lines (C),
- an interface circuit (17) connected to external data lines (DT) and address lines (AD) for exchanging data and transferring external address signals on the corresponding internal lines (ADi),
- a user control unit (3) receiving external control signals (CD) and designed notably to monitor the said exchange of data according to the said external control signals (CD),
- a state machine (2) designed to execute at least one algorithm activatable by means of the user control unit (3) according to the external control signals (CD) received, the execution of the said algorithm having the effect of producing output signals (Ci),
the said memory being characterised in that it has detection means (3B) sensitive to predetermined external control signals and first selection means (13) controlled by the said detection means (3B) in order to make the memory function selectively in a normal mode or an emulation mode and in that the said first selection means (13) are designed to put in normal mode the said output signals (Ci) from the state machine (2) on the said internal control lines (C) and, in emulation mode, to put at least some (CO) of the said internal address lines (ADi) in communication with the said internal control lines (C).

2. Memory according to Claim 1, characterised in that the said state machine (2) has a sequencer (2B) synchronised by at least one basic clock signal (CK0) and in that second selection means (15) controlled by the said detection means (3B) are designed to deliver the said basic clock signal or signals (CK0) selectively from an internal clock (2C) in normal mode or from at least one of the said internal address lines (ADi) in emulation mode.

3. Memory according to one of Claims 1 or 2, characterised in that, the said state machine being provided with input terminals designed to receive input signals (ST) from at least one of the circuits of the memory, third selection means (16) controlled by the said detection means (3B) are designed to supply in emulation mode the said input signals (ST) to the said interface circuit (17) with a view to putting them on the said external data lines (DT).

4. Memory according to Claim 3, characterised in that the said interface circuit (17) and the said first, second and third selection means (13, 15, 16) allow operation in real time.

5. Memory according to one of Claims 1 to 4, characterised in that, the said state machine being designed to control a plurality of circuits (2B, 4, 6, 10, 11, 12) of the memory, the said internal control lines (C) constitute a control bus and in that at least some of the said controlled circuits are provided with decoders connected to the said bus so that the number of lines constituting the control bus (C) is not greater than the number of internal address lines (ADi).

6. Memory according to one of Claims 1 to 5, characterised in that in normal mode the said user control unit (3) is designed to operate in response to two successive commands:
- a first pre-positioning command in response to which the user control unit (3) identifies the type of operation to be effected, such as the erasure or programming of cells of the matrix (1) and
- a second execution command in response to which the user control unit (3) actuates the loading into the internal registers (AD-R, DTi-R) of the execution parameters, such as the address or the data to be written, of the operation to be performed,
the said predetermined external control signals being applied before the said first positioning command.
